# EUROPÄISCHE PATENTSCHRIFT

(11) **EP 1 238 288 B1**
(45) Veröffentlichungstag und Bekanntmachung des Hinweises auf die Patenterteilung: **21.07.2004**
(21) Anmeldenummer: 00987376.1
(22) Anmeldetag: 09.12.2000
(51) Int. Cl.: G01R 31/36, G01R 1/20

(54) **BATTERIESENSORVORRICHTUNG**
BATTERY SENSOR DEVICE
DISPOSITIF DE CAPTEUR POUR BATTERIE

(30) Priorität: 18.12.1999 DE 19961311
(43) Veröffentlichungstag der Anmeldung: 11.09.2002
(60) Teilanmeldung: 04005840.6
(73) Patentinhaber: Bayerische Motoren Werke Aktiengesellschaft, 80809 München (DE)
(72) Erfinder: HEIM, Andreas, 84034 Landshut (DE)
(86) Internationale Anmeldenummer: PCT/EP2000/012457
(87) Internationale Veröffentlichungsnummer: WO 2001/044825

(56) Entgegenhaltungen:
- WO-A-99/54744
- DE-A- 3 532 044
- US-A- 4 572 878
- US-A- 5 877 563

## Beschreibung

Die Erfindung betrifft eine Batteriesensorvorrichtung nach dem Oberbegriff des Patentanspruchs 1.

Ein solche Batteriesensorvorrichtung ist aus der DE 35 32 044 A1 bekannt.

Eine Batteriesensorvorrichtung ist femer beispielsweise aus der US 5,939,861 bekannt. Bei dieser bekannten Vorrichtung ist der Batteriesensor in einer eigens für diesen vorgesehenen Vertiefung im Batteriedeckel angeordnet und muß an beiden Polen der Batterie befestigt werden.

Für die Überwachung, Steuerung und Regelung eines Kraftfahrzeugbordnetzes, wie Energieverteilung, Energiesteuerung und insbesondere Ladebilanzierung der Batterien, sind diverse Vorrichtungen und Verfahren bekannt. Je nach Anwendungsfall sind üblicherweise zumindest die Meßgrößen Batteriestrom, Batteriespannung und Batterietemperatur notwendig. Zur Erfassung des Batteriestroms werden üblicherweise Sensoren in der Anschlußleitung zur Batterie verwendet. Die Batteriespannung und die Batterietemperatur werden meist mittels separater Sensoren direkt an den Batteriepolen oder entfemt davon gemessen. Nach dem Stand der Technik werden somit üblicherweise drei völlig unabhängige Einrichtungen verwendet, für die in jedem Fahrzeug gesondert Bauraum geschaffen werden muß und deren Informationen zur Weiterverarbeitung meist an übergeordnete Steuergeräte weitergeleitet werden müssen.

Aus der WO 99/54744 A1 ist eine Batteriemessklemme mit einer Befestigungsmanschette bekannt, mit der sie mit dem positiven Anschluss-Pol einer Batterie thermisch und elektrisch leitend fest verbunden ist. Sie enthält in ihrem Innern Sensoren sowie Mittel, um die von den Sensoren erzeugten Signale zu verarbeiten. Zur Energieversorgung der Sensoren und Verarbeitungsmittel ist die Batteriemessklemme über ein Batteriekabei auch mit dem negativen Anschlusspol der Batterie verbunden.

Die Erfindung beschäftigt sich mit der Aufgabe einen kompakteren Batteriesensor zu schaffen.

Diese Aufgabe wird durch die Merkmale des Patentanspruchs 1 gelöst. Vorteilhafte Weiterbildungen der Erfindung sind die Gegenstände der abhängigen Ansprüche.

Durch die Erfindung wird ein integrierter Batteriesensor geschaffen, der in jedes Fahrzeug mit nur wenig Zusatzaufwand bei nur geringem erforderlichen Bauraum eingebaut werden kann. Zusätzlich wird durch die kompakte Bauform und die Integration mehrerer notwendiger Bauteile die Ausfallwahrscheinlichkeit gesenkt.

In der Zeichnung ist ein Ausführungsbeispiel der Erfindung dargestellt. Es zeigen
- Fig. 1a: die Draufsicht einer ersten möglichen Konstruktion der erfindungsgemäßen integrierten Baueinheit bestehend aus Batteriesensor und Befestigungsvorrichtung in zweidimensionaler Darstellung,
- Fig. 1b: den Schnitt B-B durch Fig. 1a,
- Fig. 2: die erste mögliche Konstruktion der erfindungsgemaßen integrierten Baueinheit bestehend aus Batteriesensor und Befestigungsvorrichtung in dreidimensionaler Darstellung,
- Fig. 3: eine genauere schematische Darstellung des Batteriesensors bestehend aus dem Meßshunt und der Elektronikeinheit,
- Fig. 4: eine genauere schematische Darstellung der Elektronikeinheit,
- Fig. 5a: schematisch eine zweite mögliche Konstruktion der erfindungsgemäßen integrierten Baueinheit bestehend aus Batteriesensor und Befestigungsvornchtung in zweidimensionaler Darstellung,
- Fig. 5b: eine leicht von Fig. 5a abgewandelte Konstruktion,
- Fig. 6a: und
- Fig. 6b: weitere Möglichkeiten zur Befestigung der Elektronikeinheit auf dem Meßshunt,
- Fig. 7a: eine erste Ausgestaltung des Meßshunts und
- Fig. 7b: eine zweite Ausgestaltung des Meßshunts.

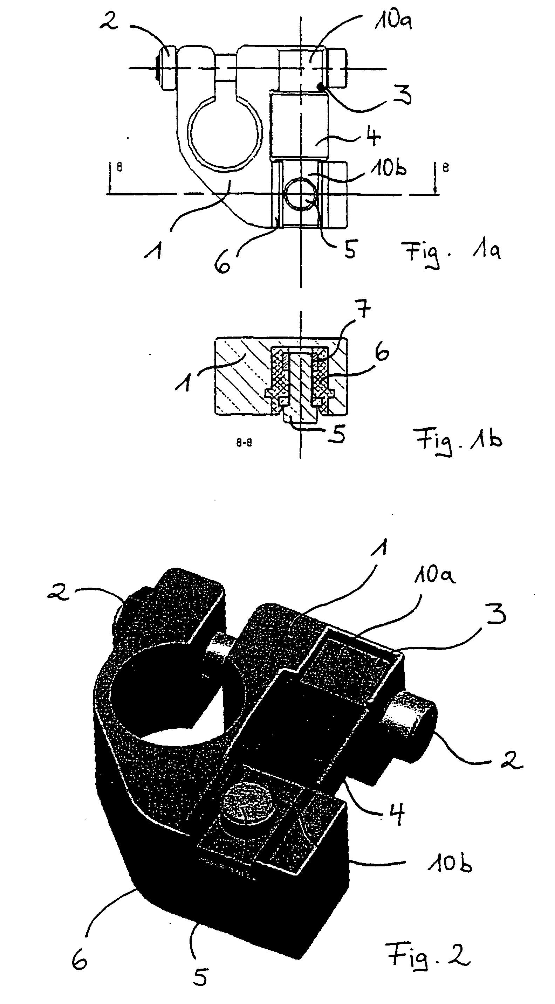

In Fig. 1a ist die Befestigungsvorrichtung des Batteriesensors als vorzugsweise übliche Batterie-Messingklemme bestehend aus einem Klemmenkörper 1 und einer Klemmschraube 2 dargestellt. Der Batteriesensor 3, 4 ist im wesentlichen aus einem Meßshunt 3 und einer Elektronikeinheit 4 aufgebaut. In Fig. 1a sind lediglich die zwei als mechanische Träger ausgebildeten Widerstandsanschlüsse (10a, 10b; vgl. auch Fig. 2) des Meßshunts 3 und eine Kunststoffumspritzung der Elektronikeinheit 4 zu sehen. Der Batteriesensor 3,4 und die Befestigungsvorrichtung 1, 2 sind erfindungsgemäß zu einer integrierten Baueinheit zusammengefaßt. Die Befestigungsvorrichtung 1,2 muß nur an einem einzigen Pol einer Batterie, z. B. am Minuspol, angeschlossen werden. Die Baueinheit, bestehend aus der Befestigungsvorrichtung 1, 2 und dem Batteriesensor 3,4, ist in Form und Größe an die (hier nicht eigens dargestellte) bekannte, nach der polnischen DIN 72311 (Teil15) spezifizierte Batteriepolwanne angepaßt.

Der erste, in Fig. 1a oben dargestellte Widerstandsanschluß 10a ist leitend, der zweite, in Fig. 1a unten dargestellte Widerstandsanschluß 10b ist isolierend über ein Isolierteil 6 am Klemmenkörper 1 befestigt. Am zweiten Widerstandsanschluß 10b ist beispielsweise mittels einer Schraube 5 und einer im Isolierteil 6 eingebetteten Schraubenmutter 7 (vgl. Fig. 1b) der Kabelschuh eines gewöhnlichen Anschlußkabels anschließbar. Beim vorliegenden Ausführungsbeispiel, bei dem die Klemme 1, 2 am Minuspol der Batterie angeschlossen werden soll, verbindet das (hier nicht dargestellte) Anschlußkabel den ausgangsseitigen Widerstandsanschluß 10b des Meßshunts 3 mit der Kraftfahrzeugmasse.

In Fig. 2 ist zur Verdeutlichung der Erfindung die in Fig. 1a und 1 b dargestellte Baueinheit dreidimensional dargestellt. Die gleichen Bauteile sind mit gleichen Bezugszeichen versehen.

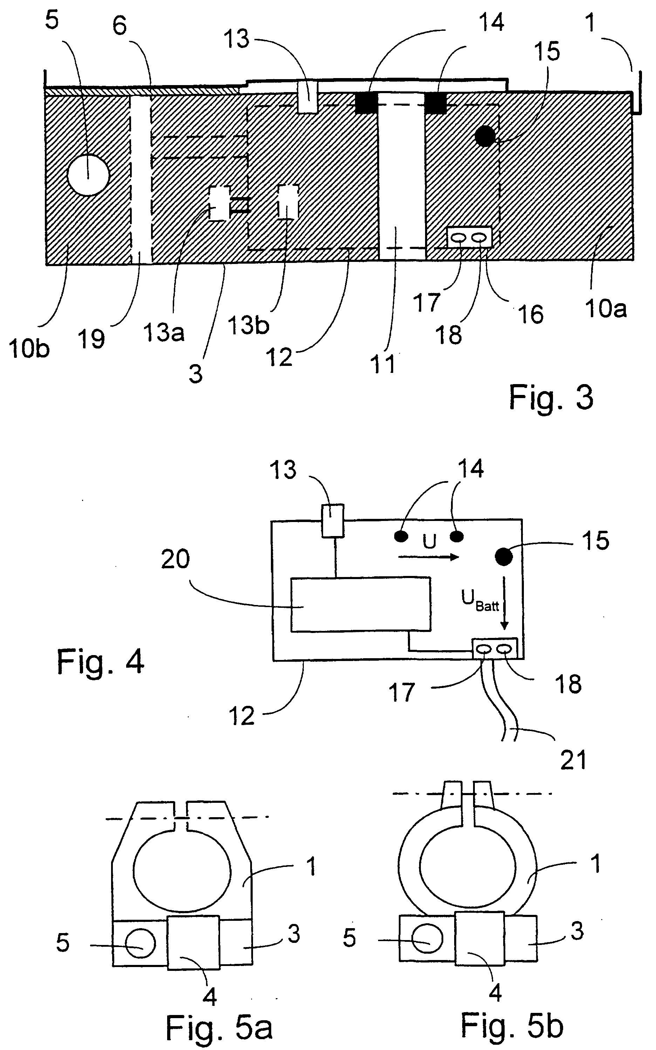

In Fig. 3 sind im wesentlichen die Details des Meßshunts 3, mögliche Anordnungen eines Temperatursensors 13, 13a oder 13b und einer möglichen Verbindung dieser Bauteile mit der Elektronikeinheit 4 dargestellt. Der Meßshunt 3 besteht aus einem Widerstandselement 11 und zwei planaren Widerstandsanschlüssen 10a und 10b. Die Widerstandsanschlüsse 10a und 10b sind vorzugsweise stabil ausgebildete Kupferflächen. Das Material des Widerstandselements 1 ist vorzugsweise Manganin, Zeranin oder Isaohm. Kupfer und Manganin/Zeranin/lsaohm weisen in etwa den gleichen Temperaturausdehnungskoeffizienten wie das übliche Platinenmaterial FR4 (Mischmaterial mit Epoxyharz als Hauptbestandteil) auf. Dieses Platinenmaterial wird vorzugsweise auch für die Trägerplatine 12 der Elektronikeinheit 4 verwendet, die in Fig 3 ohne Kunststoffumspritzung dargestellt ist. Daher kann die Trägerplatine 12 der Elektronikeinheit 4 gemäß Fig. 3 ähnlich der SMD-Technik über bloße Lötstellen 14 an den Widerstandsanschlüssen 10a und 10b befestigt werden. Alternativ kann die Trägerplatine 12 auch über um 90° nach oben gebogene kurze Senseleitungen der Widerstandsanschlüsse 10a und 10b am Meßshunt 3 leitend befestigt werden. Die Lötstellen 14 oder die Anschlüsse der Senseleitungen sind möglichst nahe am Widerstandselement 11 angeordnet. Über die Lötstellen 14 wird das Widerstandselement 11 schaltungstechnisch in die Elektronikeinheit 4 integriert.

Die Elektronikeinheit 4 bzw. die Trägerplatine 12 ist in Fig. 3 mit einem Temperatursensor 13 zur Messung der Batterietemperatur verbunden. Alternative Anordnungen des Temperatursensors sind gestrichelt mit den Bezugszeichen 13a und 13 b dargestellt. Der Temperatursensor 13 ist wärmeleitend beispielsweise mittels Wärmeleitkleber direkt am Klemmenkörper 1 angeordnet. Diese Anordnung ermöglicht eine sehr genaue Temperaturmessung, ist jedoch etwas aufwendiger als die Anordnung der Temperatursensoren 13a und 13b, die wärmeleitend am Widerstandsanschluß 10b angebracht sind. Der Temperatursensor 13a ist vereinfacht über Anschlußdrähte mit der Trägerplatine 12 befestigt. Der Temperatursensor 13b ist beispielsweise über Lötstellen mit der Trägerplatine 12 verbunden, um die Anschlußdrähte zu verhindern. Für den Temperatursensor 13b ist jedoch ggf. eine Aussparung in der Trägerplatine 12 erforderlich.

Die Elektronikeinheit 4 bzw. die Trägerplatine 12 weist einen beispielsweise zweipoligen Stecker 16 auf. Am Pin 18 des Steckers 16 ist ein Versorgungskabel zum anderen Pol der Batterie, hier zum Pluspol, anschließbar. Am Pin 17 des Steckers 16 ist beispielsweise eine bidirektionale Kommunikationsleitung zu anderen Elektronikgeräten im Kraftfahrzeug anschließbar. Alternativ kann die Kommunikationsleitung auch zwei Pins benötigen (z. B. bei Verwendung eines CAN-Buses). In einer dritten Alternative kann die Kommunikation jedoch auch per Funkübertragung vorgenommen werden. Anstelle einer Verbindung über einen Stecker 16 kann aus Platzspargründen auch eine direkte Verbindung der Anschlussleitungen mit der Platine vorgesehen werden (z. B. durch Löten, Bonden oder Schweißen). (Die Alternativen sind hier nicht dargestellt.)

Schließlich ist in Fig. 3 und in Fig. 4 ein erster Spannungsabgriff 15 zur Messung der Batteriespannung U_{Batt} gezeigt, der mit dem batteriepolseitigen (z. B. zum Minuspol) Widerstandsanschluß 10a leitend verbunden ist. Der zweite Spannungsabgriff zur Messung der Batteriespannung U_{Batt} wird durch den Pin 18 gebildet (z. B. zum Pluspol der Batterie).

In Fig. 4 sind weitere Details der Trägerplatine 12 bzw. der Elektronikeinheit 4 dargestellt. Die Trägerplatine 12 bzw. die Elektronikeinheit 4 weist eine Meß-, Auswerte- und Steuereinheit 20 auf. Die Einheit 20 erfaßt die Batteriespannung U_{Batt}, die Spannung U zwischen den beiden Lötstellen 14 und die Batterietemperatur. Aus der Spannung U kann der Batteriestrom (I) berechnet werden. Hierzu ist beispielsweise der Widerstandswert (R) des Widerstandselements 11 in der Einheit 20 abgespeichert. Die Einheit 20 weist vorzugsweise einen Mikroprozessor und einen Speicher auf. Auch kann die Einheit 20 übliche Verstärker und A/D-Wandler zur Meßaufbereitung enthalten. Die Einheit 20 kann beliebige weitere Batterie-Indikatorgrößen, wie z. B. den Ladezustand oder den Alterungszustand, ermittelt. Weiterhin kann die Einheit 20 ihrerseits über die Kommunikationsleitung nicht nur Informationen übertragen, sondern auch weitere Informationen von anderen Steuergeräten erhalten und diese mit den Batteriegrößen weiterverarbeiten. Die Kommunikationsleitung und die Versorgungsleitung zum Stecker 16 sind als Kabelbaum 21 zusammengefaßt dargestellt.

Abhängig von den der Einheit 20 vorliegenden Informationen kann diese einen Leistungsschalter 19 ansteuern, der eine im Widerstandsanschluß 10b vorliegende Unterbrechung schließen oder öffnen kann. Hierbei kann beispielsweise in Notfällen die Batteneversorgung des Kraftfahrzeuges abgeschaltet werden. Alternativ kann hierzu der Leistungsschalter 19 auch in einen der beiden Anschlusskabel zum Pluspol oder zum Minuspol der Batterie integriert und von der Einheit 20 angesteuert werden.

In Fig. 5a ist erganzend lediglich schematisch eine zweite mögliche Konstruktion der erfindungsgemäßen integrierten Baueinheit bestehend aus Batteriesensor und Befestigungsvorrichtung dargestellt. Hierbei wird durch die strichpunktierte Linie die Bohrung für die Klemmschraube 2 angedeutet. Diese Konstruktion weicht nur darin von der ersten Konstruktion ab, daß der Batteriesensor 3, 4 örtlich stärker von der Klemmschraube 2 abgesetzt ist und damit von möglichen Verspannungen bei einer Befestigung des Klemmkörpers 1 entkoppelt ist.

Fig. 5b zeigt eine der Fig. 5a sehr ähnliche Konstruktion, bei der jedoch zwischen dem Klemmkörper 1 und dem Meßshunt 3 eine Verjüngung vorgesehen ist, um Materialspannungen im Klemmkörper 1 zu vermeiden.

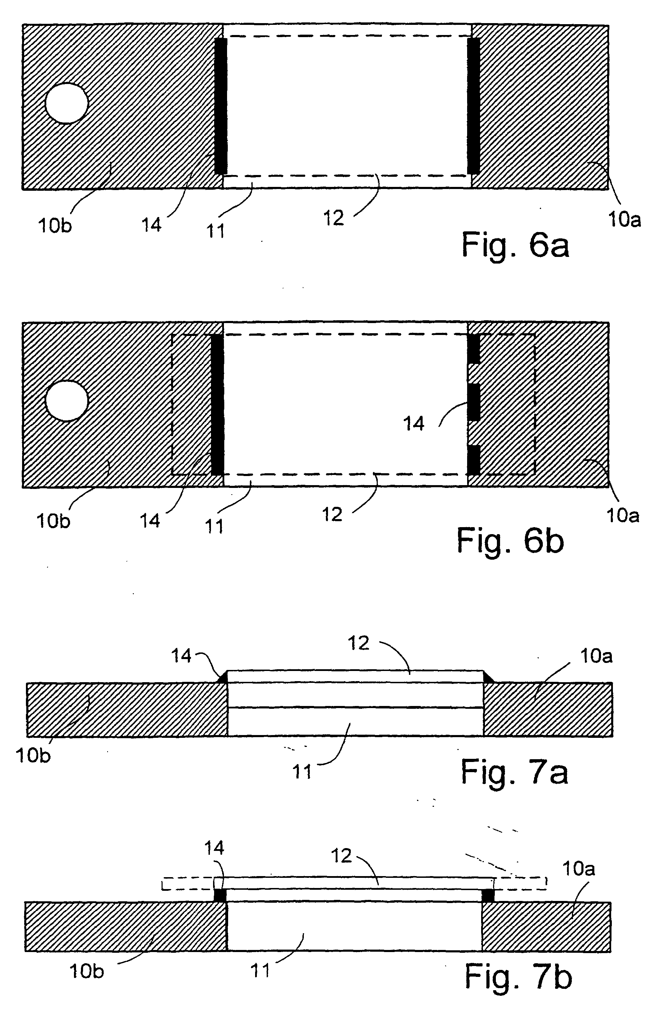

In den Figuren 6a bis 7b sind weitere Ausgestaltungsmöglichkeiten des Meßshunts 3 bestehend aus dem Widerstandselement 11 und den beiden Widerstandsanschlüssen 10a und 10b sowie der Befestigung der Elektronikeinheit 4 bzw. deren Tragerplatine 12 dargestellt. Die Widerstandsanschlüsse 10a und 10b sind vorzugsweise (wie auch in Fig. 3) planar ausgebildete Kupferflächen. Das Material des Widerstandselements 1, vorzugsweise Manganin oder Zeranin, ist wie auch in Fig. 3 zwischen den Widerstandselementen 10a und 10b angeordnet.

in den Figuren 6a bis 7b ist die Trägerplatine 12 der Elektronikeinheit 4 (auch ähnlich der SMD-Technik) über Lötstellen 14 an den Widerstandsanschlüssen 10a und 10b befestigt. Dabei bilden in Fig. 6a (und in Fig. 7a, Seitenansicht von Fig. 6a) die Lötstellen 14 eine langgezogene Linie entlang der Kante der Trägerplatine 12. Hierzu sind vorzugsweise an den Kanten der Trägerplatine zumindest zum Teil offene Leiterbahnen für die Lötstellen vorgesehen. Die Lötlinien 14 können auch unterbrochen sein bzw. sich auch aus beabstandeten Punkten zusammensetzen. Die Ausgestaltung nach Fig. 6a (bzw. Fig. 7a) setzt voraus, dass die Breite der Tragerplatine 12 nicht viel größer als die Breite des Widerstandelements 11 ist; denn die Verlötung muss möglichst nahe am Widerstandselement 11 vorgesehen werden. Vorzugsweise ist die Konstruktion des Meßshunts dabei gemäß Fig. 7a derart, dass sich zwischen dem Widerstandselement 11 und der Trägerplatine 12 ein Hohlraum ergibt. Die Dicke des Widerstandselementes 11 ist also kleiner als die der Widerstandsanschlüsse 10a und 10b. Durch diesen Hohlraum ist es möglich, die Trägerplatine 12 bei Bedarf beidseitig zu bestücken.

Alternativ kann gemäß Fig. 6b (und Fig. 7b, Seitenansicht von Fig. 6b) die Trägerplatine 12 auch durch Lötstellen 14 an der Unterseite der Platine 12 mit den Widerstandsanschlüssen 10a und 10b möglichst nahe am Widerstandselement 11 verbunden sein (ähnlich Fig. 3). Im Unterschied zu Fig. 3 wird hierbei zur mechanischen Stabilisierung (wie in Fig. 6a) eine durchgezogen (Fig. 6b links) oder eine unterbrochene (Fig. 6b rechts) Lötlinie vorgesehen. Über die Lötstellen 14 wird das Widerstandselement 11 immer auch schaltungstechnisch in die Elektronikeinheit 4 integriert. Die Ausgestaltung nach Fig. 6b kann mit der Konstruktion des Meßshunts gemäß Fig. 7a oder Fig. 7b kombiniert werden. Ist eine Bestückung der Unterseite der Trägerplatine 12 nicht erforderlich, ist eine Konstruktion gemäß Fig. 7b möglich, bei der kein Hohlraum zwischen dem Widerstandselement 11 und der Trägerplatine 12 vorgesehen ist. Bei einer Ausgestaltung nach Fig. 6b und Fig. 7b kann die Breite der Trägerplatine 12 auch größer als die Breite des Widerstandelements 11 sein.

Bei jeder Ausgestaltung können anstelle von Lötstellen (14) auch Klebstellen (14), z.B. mittels eines elektrisch leitenden und warmeleitenden Klebers, vorgesehen werden.

Grundsätzlich wird demnach erfindungsgemäß die Elektronikeinheit 4 bzw. die Trägerplatine 12 der Elektronikeinheit 4 an den planaren Widerstandsanschlüssen 10a und 10b mittels eines elektrisch leitenden Materials 14 (z. B. Lot oder Kleber) befestigt. Die Löt- oder Klebestellen 14 dienen somit sowohl zur elektrischen bzw. schaltungstechnischen Integration des Meßshunts bzw. des Widerstandselements 11 in die Elektronikeinheit 4 als auch zur mechanischen Befestigung der Elektronikeinheit 4 bzw. deren Trägerplatine 12 am Meßshunt bzw. an dessen Widerstandsanschlüssen 10a und 10b.

## Patentansprüche

1. Batteriesensorvorrichtung mit einer direkt an einem Pol einer Kraftfahrzeugbatterie anschließbaren Befestigungsvorrichtung, wobei der Batteriesensor (3, 4) und die Befestigungsvorrichtung zu einer integrierten Baueinheit zusammengefaßt sind, die Befestigungsvorrichtung nur an einem einzigen Pol angeschlossen wird, die Befestigungsvorrichtung eine für Batterieanschlußkabel im Kraftfahrzeug übliche Klemme (1, 2) aufweist und die Baueinheit in Form und Größe an übliche Batteriepolwannen angepaßt ist, **dadurch gekennzeichnet, daß** der Batteriesensor (3, 4) aus einem planaren Meßshunt (3) und einer Elektronikeinheit (4) besteht, daß der Meßshunt (3) als Widerstandselement (11) mit zwei als mechanische Träger ausgebildeten Widerstandsanschlüssen (10a, 10b) ausgestaltet ist, daß die Elektronikeinheit (4) an den Widerstandsanschlüssen (10a, 10b) befestigt ist und daß das Widerstandselement (11) schaltungstechnisch in der Elektronikeinheit (4) integriert ist.

2. Batteriesensorvorrichtung nach Patentanspruch 1, **dadurch gekennzeichnet, daß** der Batteriesensor (3, 4) aus einem planaren Meßshunt (3) und einer Elektronikeinheit (4) besteht, daß der Meßshunt (3) als Widerstandselement (11) mit zwei als mechanische Träger ausgebildeten Widerstandsanschlüssen (10a, 10b) ausgestaltet ist, daß die Elektronikeinheit (4) bzw. die Trägerplatine (12) der Elektronikeinheit (4) an den planaren Widerstandsanschlüssen (10a, 10b) mittels eines elektrisch leitenden Materials (14) befestigt ist.

3. Batteriesensorvorrichtung nach einem der Patentansprüche 1 oder 2, **dadurch gekennzeichnet, daß** der Batteriesensor (3, 4) über einen ersten Widerstandsanschluß (10a) leitend und über den zweiten Widerstandsanschluß (10b) isolierend am Klemmenkörper (1) befestigt ist und daß am zweiten Widerstandsanschluß (10b) das dem einen Pol der Batterie zugeordnete Anschlußkabel für die Kraftfahrzeugversorgung anschließbar ist.

4. Batteriesensorvorrichtung nach einem der Patentansprüche 1 bis 3, **dadurch gekennzeichnet, daß** die Elektronikeinheit (4) mit einem Temperatursensor (13; 13a; 13b) verbunden ist, der wärmeleitend an einem Widerstandsanschluß (10a, 10b) oder direkt am Klemmenkörper (1) angeordnet ist.

5. Batteriesensorvorrichtung nach einem der Patentansprüche 1 bis 4, **dadurch gekennzeichnet, daß** die Elektronikeinheit (4) einen Stecker (16) aufweist, an dem zumindest ein Versorgungskabel zum anderen Pol der Batterie anschließbar ist.

6. Batteriesensorvorrichtung nach einem der Patentansprüche 1 bis 5, **dadurch gekennzeichnet, daß** die Elektronikeinheit (4) einen Stecker (16) aufweist, an dem zumindest eine Kommunikationsleitung zu anderen Elektronikgeräten im Kraftfahrzeug anschließbar ist.

7. Batteriesensorvorrichtung nach einem der Patentansprüche 1 bis 6, **dadurch gekennzeichnet, daß** die Elektronikeinheit (4) eine Meß-, Auswerteund/oder Steuereinheit (20) aufweist, die die Batteriespannung (U_{Batt}), den Batteriestrom, die Batterietemperatur und/oder andere Batterie-Indikatorgrößen ermittelt.

8. Batteriesensorvorrichtung nach einem der Patentansprüche 1 bis 7, **dadurch gekennzeichnet, daß** ein Widerstandsanschluß (10b) eine über einen Leistungsschalter (19) schließbare Unterbrechung aufweist und daß der Leistungsschalter (19) von der Meß-, Auswerte- und/oder Steuereinheit (20) ansteuerbar ist.

## Claims

1. Battery sensor device with a fastening device which can be connected directly to a pole of a motor vehicle battery, wherein the battery sensor (3, 4) and the fastening device are combined to form an integrated structural unit, the fastening device is only connected to a single pole, the fastening device has a clamp (1, 2) which is conventional for battery connection cables in the motor vehicle and the structural unit is adapted with respect to shape and size to conventional battery pole troughs, **characterised in that** the battery sensor (3, 4) comprises of a planar measuring shunt (3) and an electronic unit (4), **in that** the measuring shunt (3) is designed as a resistance element (11) with two resistance connections (10a, 10b) designed as mechanical carriers, **in that** the electronic unit (4) is fastened to the resistance connections (10a, 10b) and **in that** the resistance element (11) is integrated in the electronic unit (4) in terms of circuit technology.

2. Battery sensor device according to claim 1, **characterised in that** the battery sensor (3, 4) comprises of a planar measuring shunt (3) and an electronic unit (4), **in that** the measuring shunt (3) is designed as a resistance element (11) with two resistance connections (10a, 10b) designed as mechanical carriers, **in that** the electronic unit (4) or the carrier board (12) of the electronic unit (4) is fastened to the planar resistance connections (10a, 10b) by means of an electrically conductive material (14).

3. Battery sensor device according to either one of claims 1 or 2, **characterised in that** the battery sensor (3, 4) is fastened in a conductive manner via a first resistance connection (10a) and in an insulating manner via the second resistance connection (10b) to the clamp body (1) and **in that** the connection cable for the motor vehicle supply associated with a pole of the battery can be connected to the second resistance connection (10b).

4. Battery sensor device according to any one of claims 1 to 3, **characterised in that** the electronic unit (4) is connected to a temperature sensor (13; 13a; 13b) which is arranged in a heat-conducting manner on a resistance connection (10a, 10b) or directly on the clamp body (1).

5. Battery sensor device according to any one of claims 1 to 4, **characterised in that** the electronic unit (4) has a connector (16) to which at least one supply cable to the other pole of the battery can be connected.

6. Battery sensor device according to any one of claims 1 to 5, **characterised in that** the electronic unit (4) has a connector (16) to which at least one communication line to other electronic equipment in the motor vehicle can be connected.

7. Battery sensor device according to any one of claims 1 to 6, **characterised in that** the electronic unit (4) has a measuring, analysing and/or control unit (20) which determines the battery voltage (U_{batt}), the battery current, the battery temperature and/or other battery indicator variables.

8. Battery sensor device according to any one of claims 1 to 7, **characterised in that** a resistance connection (10b) has an interruption which can be closed via a power switch (19) and **in that** the power switch (19) can be controlled by the measuring, analysing and/or control unit (20).

## Revendications

1. Dispositif de capteurs de batterie avec un dispositif de fixation pouvant être raccordé directement à un pôle d'une batterie d'un véhicule automobile, le capteur de batterie (3, 4) et le dispositif de fixation étant regroupés en une unité modulaire intégrée, le dispositif de fixation n'étant raccordé qu'à un seul pôle, comportant une pince (1, 2) classique pour des câbles de raccordement de batterie dans un véhicule, que la forme et la taille de l'unité modulaire étant adaptées aux bornes de pôle de batterie classiques,
**caractérisé en ce que**
le capteur de batterie (3, 4) se compose d'un shunt de mesure (3) planaire et d'une unité électronique (4), le shunt de mesure (3) est configuré en tant que grille de résistance (11) avec deux branchements de résistance (10a, 10b) conçus en tant que supports mécaniques, l'unité électronique (4) est fixée sur les branchements de résistance (10a, 10b) et la grille de résistance (11) est intégrée dans l'unité électronique (4) suivant la technique de montage.

2. Dispositif de capteurs de batterie selon la revendication 1,
**caractérisé en ce que**
le capteur de batterie (3, 4) se compose d'un shunt de mesure (3) planaire et d'une unité électronique (4), le shunt de mesure (3) est conçu comme grille de résistance (11) avec deux branchements de résistance (10a, 10b) conçus en tant que supports mécaniques, l'unité électronique (4) et/ou la platine porteuse (12) de l'unité électronique (4) est fixée sur les branchements de résistance (10a, 10b) planaires à l'aide d'un matériau (14) assurant la conduction électrique.

3. Dispositif de capteurs de batterie selon l'une quelconque des revendications 1 ou 2,
**caractérisé en ce que**
le capteur de batterie (3, 4) est fixé sur le corps de pince (1) via un premier branchement de résistance (10a) conducteur et via un deuxième branchement de résistance (10b) isolant, et le câble de raccordement associé à un pôle de la batterie peut être connecté au deuxième branchement de résistance (10b) pour l'alimentation du véhicule.

4. Dispositif de capteurs de batterie selon l'une quelconque des revendications 1 à 3,
**caractérisé en ce que**
l'unité électronique (4) est reliée à un capteur de température (13 ; 13a ; 13b) disposé soit directement sur le corps de la borne (1), soit sur un branchement de résistance (10a, 10b) thermiquement conducteur.

5. Dispositif de capteurs de batterie selon l'une quelconque des revendications 1 à 4,
**caractérisé en ce que**
l'unité électronique (4) comporte un connecteur (16) sur lequel peut être branché au moins un câble d'alimentation menant à l'autre pôle de la batterie.

6. Dispositif de capteurs de batterie selon l'une quelconque des revendications 1 à 5,
**caractérisé en ce que**
l'unité électronique (4) comporte un connecteur (16) sur lequel peut être branchée au moins une ligne de communication menant à d'autres appareils électroniques dans le véhicule.

7. Dispositif de capteurs de batterie selon l'une quelconque des revendications 1 à 6
**caractérisé en ce que**
l'unité électronique (4) comporte une unité de mesure, d'exploitation et/ou de commande (20) qui détermine la tension de la batterie (U_{Batt}), le courant de la batterie, la température de la batterie et/ou d'autres grandeurs indicatrices de la batterie.

8. Dispositif de capteurs de batterie selon l'une quelconque des revendications 1 à 7,
**caractérisé en ce qu'**
un branchement de résistance (10b) comporte une ouverture que peut refermer un sectionneur de puissance (19), et le sectionneur de puissance (19) peut être amorcé par l'unité de mesure, d'exploitation et/ou de commande (20).
